Europäisches Patentamt

European Patent Office

Office européen des brevets

(19)

(11) **EP 1 231 711 A1**

(12) ## DEMANDE DE BREVET EUROPEEN

(43) Date de publication:
**14.08.2002 Bulletin 2002/33**

(51) Int Cl.⁷: **H03G 3/30**, H03G 3/20

(21) Numéro de dépôt: **02290351.2**

(22) Date de dépôt: **13.02.2002**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **13.02.2001 FR 0101917**

(71) Demandeur: **SAGEM S.A.**
**75015 Paris (FR)**

(72) Inventeurs:
• **Boulanger, Christophe**
**75013 Paris (FR)**
• **Pintaux, Jean-Bernard**
**75013 Paris (FR)**

(74) Mandataire: **Bloch, Gérard et al**
**Bloch & Associés**
**Conseils en Propriété Industrielle**
**2 Square de l'Avenue du Bois**
**75116 Paris (FR)**

(54) **Procédé et appareil d'égalisation de symboles de données reçus par un modem**

(57)    Selon le procédé mis en oeuvre dans le modem, on transforme chaque symbole reçu en un signal de niveau de tension spécifique, on compare (3) le niveau de symbole à une échelle des niveaux attendus pour déterminer un écart minimal (ek) de décalage, en fonction de l'écart (ek), on règle (1) des paramètres d'égalisation, par recalage relatif, entre les symboles ultérieurs et l'échelle, et on effectue le recalage relatif du symbole suivant avant d'effectuer sa comparaison à l'échelle.

On modifie (2,5) les niveaux relatifs, du signal de niveau et de l'échelle, par un facteur de gain fonction dudit écart minimal (ek).

FIGURE 1

**Description**

La présente invention concerne la reconnaissance de signaux de données reçus par un modem.

Lorsque des données doivent être transmises sur une liaison entre deux modems, il faut d'abord estimer la distorsion de propagation créée par la liaison. A cet effet, l'émetteur transmet préalablement des motifs connus de symboles, représentant des blocs de bits de diverses valeurs, et le récepteur compare les symboles reçus, distordus, aux symboles de forme nominale attendus pour déterminer, d'après les différences, un modèle de distorsion de la liaison. Ce modèle est communiqué en retour à l'émetteur et celui-ci l'utilise ensuite pour appliquer une contre-distorsion aux symboles de données utiles.

Le récepteur n'effectue plus alors qu'un filtrage d'adaptation limité, destiné à compenser les dérives lentes des caractéristiques de distorsion de la liaison, c'est-à-dire égaliser la transmission des différentes composantes du symbole.

La présente invention porte sur cette adaptation ou égalisation des signaux de données utiles.

De façon classique, le filtre adaptateur d'égalisation est placé en tête du récepteur et après transformation de la forme du symbole reçu en un niveau continu de tension spécifique à cette forme, un comparateur multiniveaux, usuellement désigné par le terme anglais " slicer ", positionne le niveau du signal adapté actuel dans une échelle de niveaux de tension nominaux de référence représentant les niveaux des divers symboles possibles. Le niveau de référence le plus proche du signal actuel est sélectionné puisque, a priori, en l'absence de bruit sur ce dernier, c'est celui qui présente la plus grande probabilité de correspondre au symbole actuel.

L'écart entre le niveau du symbole actuel et celui du symbole nominal sélectionné représente donc l'effet de la distorsion et sert à commander l'évolution de paramètres de réglage du filtre d'égalisation, pour réduire ultérieurement cet effet de la distorsion par une optimisation de l'adaptation.

Toutefois, l'adaptation n'est que stochastique stationnaire car elle ne porte que sur les caractéristiques stables, en valeur moyenne, de transmission de la liaison. Le bruit de la liaison et le bruit interne du récepteur, essentiellement aléatoires, ainsi que le bruit d'intermodulation, entre symboles transmis, échappent à tout traitement d'adaptation par corrélation à partir des signaux antérieurs.

En particulier, le bruit fait dériver le gain du filtre, si bien que la dérive d'amplitude ainsi engendrée sur le signal reçu l'éloigne de son niveau nominal et augmente donc la probabilité pour que le comparateur multiniveaux sélectionne un niveau de l'échelle qui n'est pas le bon.

En outre, en parallèle sur l'entrée du comparateur, se trouve un décodeur de prise de décision quant à la reconnaissance des symboles, décodeur de Viterbi ou autre, qui a sensiblement la même fonction que le comparateur mais comporte une pluralité d'étages multiniveaux en cascade pour analyser une pluralité correspondante de symboles antérieurs et ainsi déterminer avec précision la distorsion pour effectuer une correction fine avant de prendre cycliquement une décision de reconnaissance de l'un des symboles stockés.

La dérive ci-dessus perturbe donc le fonctionnement du comparateur de rétroaction, traitant le symbole actuel, et celui du décodeur de prise de décision de reconnaissance d'un symbole antérieur.

La présente invention vise à atténuer cette dérive.

A cet effet, l'invention concerne tout d'abord un procédé d'égalisation de signaux de symboles de données reçus par un modem, dans lequel :

- on transforme chaque symbole reçu actuel en un signal de niveau de tension spécifique à chaque symbole possible,
- on compare le niveau de symbole actuel à une échelle des niveaux attendus de symboles pour déterminer un écart minimal de décalage du symbole actuel dans l'échelle,
- en fonction de l'écart, on règle des paramètres d'égalisation, par recalage relatif, entre les symboles ultérieurs et l'échelle, et
- on effectue le recalage relatif du symbole reçu suivant avant d'effectuer sa comparaison à l'échelle,

procédé caractérisé par le fait qu'on modifie les niveaux relatifs, du signal de niveau et de l'échelle, par un facteur de gain fonction dudit écart minimal.

Ainsi, la valeur de la dérive est estimée et on peut donc la corriger. En outre, la valeur de correction peut être obtenue par des calculs relativement simples, donc rapidement et avec des moyens limités.

On notera qu'une division de l'échelle par le facteur de gain équivaut à une multiplication du signal de symbole actuel par ce facteur.

De préférence, on estime, d'après l'écart minimal, une puissance de bruit, associée au symbole adapté actuel bruité, que l'on retranche à la puissance de ce dernier, que l'on a calculée, pour déterminer une puissance de symbole utile,

- on calcule le rapport entre la puissance du symbole actuel bruité et la puissance du symbole utile, et
- pour effectuer le recalage du symbole suivant, on modifie les niveaux relatifs, du signal de niveau et de l'échelle, par un facteur de gain représentant ledit rapport des puissances.

Avantageusement, on estime le bruit par calcul de la variance portant sur un nombre déterminé de symboles antérieurs.

Dans un mode de mise en oeuvre du procédé, on représente vectoriellement le signal de symbole bruité et le signal de symbole non-bruité et on calcule l'inverse du carré du cosinus de l'angle formé entre les vecteurs du signal bruité et du signal non bruité, pour obtenir le facteur de gain à appliquer au symbole suivant.

Dans un autre mode, on calcule le rapport d'amplitudes bruit/signal bruité, que l'on considère comme étant une valeur de sinus, pour calculer l'inverse du carré du cosinus correspondant afin d'obtenir le facteur de gain.

Dans ces deux modes, une table trigonométrique de sinus de cosinus permet d'obtenir les valeurs recherchées.

L'invention concerne aussi un modem pour la mise en oeuvre du procédé selon l'invention, comportant des moyens d'égalisation de signaux de divers symboles reçus, commandant des moyens de transformation des symboles reçus en signaux correspondants de niveau spécifiques et prévus pour les appliquer à des moyens de comparaison multiniveaux agencés pour déterminer un écart minimal entre un symbole reçu actuel et des niveaux nominaux et d'une échelle des divers symboles attendus et commander en retour les moyens d'égalisation, caractérisé par le fait que les moyens de comparaison multiniveaux sont agencés pour en outre commander des moyens de calcul d'un taux de bruit des symboles reçus, prévus pour commander des moyens de contrôle de gain relatif entre les niveaux des symboles reçus et les niveaux nominaux de l'échelle.

L'invention sera mieux comprise à l'aide de la description suivante d'une forme de mise en oeuvre préférée du procédé de l'invention, en référence au dessin annexé, sur lequel :

- la figure 1 représente schématiquement une chaîne de réception de symboles de données d'un modem,
- la figure 2 est un schéma fonctionnel équivalent de celui de la figure 1, et
- la figure 3 montre des vecteurs représentant divers signaux à traiter par la chaîne de réception.

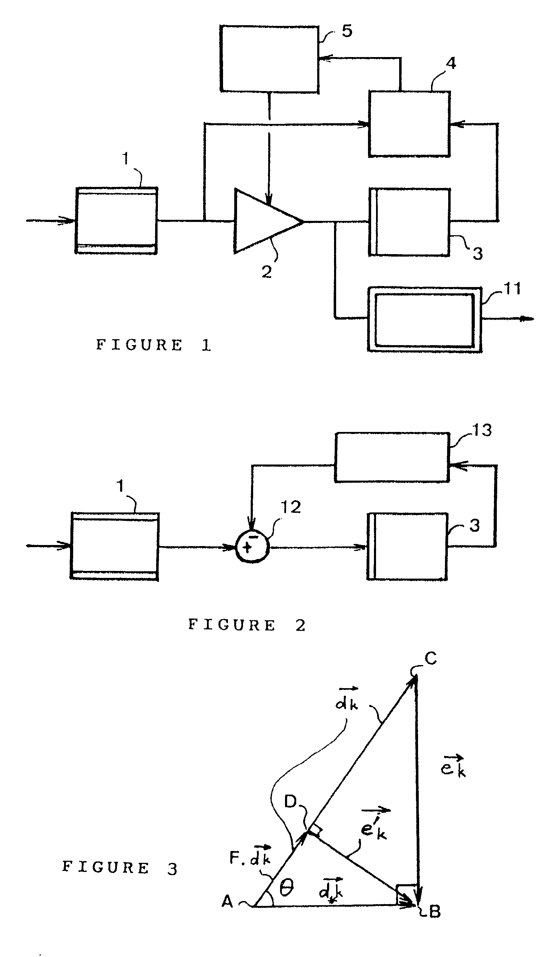

La chaîne de réception de symboles de données de la figure 1 comporte en tête un bloc de filtrage d'égalisation 1 destiné à compenser la distorsion de propagation de la liaison transmettant les symboles de données. Chaque symbole représente un bloc de plusieurs bits de valeur particulière. Dans le bloc d'égalisation 1, le symbole actuel reçu subit un traitement qui en modifie la forme afin d'en éliminer la distorsion due à la propagation.

Dans un étage de sortie du bloc d'égalisation 1 est en outre effectuée une transformation de la forme du symbole reçu actuel égalisé, en vue de faciliter les traitements aval de reconnaissance de celui-ci. Chaque symbole actuel est ainsi transformé en un signal continu présentant un niveau de tension spécifique au symbole.

Toutefois, le traitement d'égalisation des symboles reçus, s'il en corrige effectivement la forme, ne les fournit toutefois pas avec une amplitude constante, celle-ci restant sensible aux diverses perturbations intervenant lors de la transmission. Le niveau continu ci-dessus fluctue donc.

Le signal de niveau correspondant est transmis à un circuit comparateur multiniveaux 3, qui positionne le niveau actuel dans une échelle prédéterminée de niveaux nominaux de référence attendus représentant les symboles possibles.

La transformation ci-dessus du symbole actuel en un niveau continu aurait pu, en variante, être prévue en entrée du circuit comparateur multiniveaux 3.

Le niveau de l'échelle le plus proche du niveau actuel reçu, donc à écart minimal ek, indique, a priori, le symbole possible à sélectionner comme représentant le symbole émis. Les écarts ek successifs commandent, par une liaison non représentée, un bloc de calcul du bloc de filtrage d'égalisation 1 pour adapter cycliquement des coefficients de pondération d'échantillons du symbole actuel reçu et ainsi reconstituer au mieux sa forme d'émission. Un circuit 2 à gain commandé est en outre interposé entre les circuits 1 et 3 pour modifier la position relative entre le niveau de signal actuel et l'échelle, afin de corriger la fluctuation ci-dessus du niveau continu par rapport à l'échelle de référence.

Dans le schéma représenté, c'est l'échelle qui est fixe et l'amplitude du symbole courant est multipliée, dans le circuit 2 à gain commandé, par un facteur de gain agissant donc ici en amont du circuit comparateur 3, ici sur le niveau continu du symbole transformé ou bien, en option, sur le symbole non encore transformé.

La sortie du circuit à gain commandé 2 est en outre reliée à l'entrée d'un bloc 11 de décodage et de prise de décision quant à la reconnaissance d'un symbole antérieur parmi une pluralité de symboles égalisés reçus et temporairement mémorisés. Le bloc de décodage 11, ici de Viterbi, reçoit donc des symboles non seulement égalisés mais aussi corrigés par le circuit à gain commandé 2, comme expliqué plus loin, ce qui limite son risque d'erreur. Le niveau de sortie du bloc d'égalisation 1 présente, par rapport à l'échelle de référence, la fluctuation ci-dessus, ou dérive systématique, qui est due au principe d'asservissement de ce bloc d'égalisation 1 exposé ci-après. Ce niveau de sortie est appliqué à un comparateur 4 de mesure d'erreur recevant, du comparateur multiniveaux 3, le niveau nominal ou théorique sélectionné. L'écart ou erreur ek correspondant représente donc l'effet d'un défaut d'égalisation, que le circuit à gain commandé 2 tend à compenser sous la commande d'un bloc de calcul 5, recevant le signal d'erreur ek, et dont la fonction est expliquée plus loin. L'écart ek peut être considéré comme étant un bruit résultant de l'imperfection de l'égalisation.

D'une façon générale, pour égaliser les signaux de symbole reçus,

- on transforme chaque symbole reçu actuel en un signal de niveau de tension spécifique à chaque symbole possible,

- on compare le niveau du symbole actuel à l'échelle des niveaux attendus de symboles pour déterminer l'erreur ou écart minimal ek de décalage du symbole actuel dans l'échelle,

- en fonction de l'écart minimal ek, on règle des paramètres d'égalisation, par recalage relatif, entre les symboles ultérieurs et l'échelle, et

- on effectue le recalage relatif du symbole reçu suivant avant d'effectuer sa comparaison à l'échelle.

Pour effectuer le recalage du symbole suivant, on modifie les niveaux relatifs, du signal de niveau et de l'échelle, par un facteur de gain fonction de l'écart minimal ek.

Dans cet exemple, on estime à cet effet, dans le bloc de calcul 5, une puissance de bruit $e^2k$ associée au symbole adapté actuel bruité, et, après avoir calculé la puissance de ce dernier, on y retranche la puissance de bruit pour déterminer une puissance de symbole utile $d^{*2}k$, et le facteur de gain représente le rapport des puissances ci-dessus.

Comme exposé, le gain agit sur le niveau du signal actuel dans cet exemple, et non sur l'échelle, ce qui offre l'avantage d'améliorer les performances du bloc de décision 11 sans devoir en modifier l'échelle.

Pour illustrer le principe de commande en retour du circuit à gain commandé 2, la figure 2 représente le bloc d'égalisation 1 et le comparateur multiniveaux 3 reliés par un soustracteur 12 dont l'entrée négative est reliée en sortie d'un bloc de filtrage de retour de décision 13 à L étages commandé par le comparateur multiniveaux 3.

Le soustracteur 12 permet donc d'ajouter ou retrancher au symbole égalisé une combinaison linéaire de symboles antérieurs d(k-1) à d(k-L) issue du bloc de filtrage 13, et pouvant représenter une fraction de l'amplitude du symbole actuel.

La figure 3 représente un signal de vecteur non bruité $\overrightarrow{d^*k}$ représentant un niveau de symbole actuel exempt de tout défaut, c'est-à-dire égal à un niveau nominal de l'échelle.

Le signal actuel non bruité $\overrightarrow{d^*k}$ fait donc partie de l'espace vectoriel représentant les divers niveaux de l'échelle et sera agrégé aux symboles antérieurs du bloc de filtrage 13 à la fin du cycle de traitement symbole actuel. Cet espace vectoriel est représenté réduit à une horizontale portant le vecteur non bruité $\overrightarrow{d^*k}$ sur la figure 3. Le signal non bruité $\overrightarrow{d^*k}$ est donc la composante utile (qui sera agrégée) du signal bruité appliqué en entrée du comparateur multiniveaux 3, désigné par le vecteur $\overrightarrow{dk}$, associé à un vecteur de composante de parasite de bruit $\overrightarrow{ek}$ (erreur mesurée), que l'on pourrait qualifier de " déwattée ". Pour la clarté du dessin, le vecteur de bruit $\overrightarrow{ek}$ a été représenté avec une amplitude accrue.

On a ainsi :

$$\overrightarrow{dk} + \overrightarrow{ek} = \overrightarrow{d^*k}.$$

Dans cette représentation, $\overrightarrow{ek}$ représente donc en fait l'erreur négative ou correction à apporter au vecteur bruité $\overrightarrow{dk}$ pour obtenir $\overrightarrow{d^*k}$.

Comme le vecteur non bruité $\overrightarrow{d^*k}$ représente la composante du vecteur bruité $\overrightarrow{dk}$ dans l'espace vectoriel utile considéré, le vecteur de composante parasite $\overrightarrow{ek}$ est donc indépendant de cet espace vectoriel, donc perpendiculaire à celui-ci et donc au vecteur non bruité $\overrightarrow{d^*k}$. Le triangle correspondant A B C est donc rectangle en B, le vecteur non bruité $\overrightarrow{d^*k} = \overrightarrow{A B}$ étant dans l'espace vectoriel.

Le bruit, erreur ou écart $\overrightarrow{ek}$ peut s'écrire

$$\overrightarrow{ek} = \overrightarrow{bk} + \overrightarrow{ISI} + \overrightarrow{E.dk}$$

avec

$\overrightarrow{bk}$ = terme de bruit non corrélé avec le vecteur bruité $\overrightarrow{dk}$

$\overrightarrow{ISI}$ et $\overrightarrow{E.dk}$ interférences entre symboles reçus successifs, respectivement non correllée et correllée avec le vecteur bruité $\overrightarrow{dk}$.

La non-correllation ci-dessus implique donc, selon le principe expliqué plus haut, une orthogonalité des vecteurs considérés.

Ayant :

$$\overrightarrow{d^*k} = \overrightarrow{dk} + (\overrightarrow{bk} + \overrightarrow{ISI} + \overrightarrow{E.dk})$$

on obtient :

$$\overrightarrow{d^*k} = (1 + E). \overrightarrow{dk} + \overrightarrow{bk} + \overrightarrow{ISI}$$

E étant un nombre algébrique pondérant le vecteur bruité $\overrightarrow{dk}$.

Le vecteur somme $\overrightarrow{bk} + \overrightarrow{ISI}$, que l'on appellera $\overrightarrow{e'k}$, est indépendant du vecteur bruité $\overrightarrow{dk}$ et y est donc perpendiculaire en un point D sur la figure 3 pour aboutir au sommet B. Le vecteur $\overrightarrow{AD}$ représente donc (1 + E). $\overrightarrow{dk}$, que l'on désignera par $\overrightarrow{F.dk}$.

Les triangles rectangles A B C et A D B sont semblables puisqu'ils ont un angle aigu commun θ $= \widehat{BAD}$, qui représente une déviation due à l'écart $\overrightarrow{ek}$ ou encore $\overrightarrow{e'k}$.

On peut donc écrire l'égalité des rapports de modules :

$$\cos θ = \frac{/\overrightarrow{F.dk}/}{/\overrightarrow{d^*k}/} = \frac{/\overrightarrow{d^*k}/}{/\overrightarrow{dk}/}$$

d'où

$$F = \frac{/\overrightarrow{d^*k}/^2}{/\overrightarrow{dk}/^2} = \cos^2\theta$$

L'interférence relative correllée intersymboles E à corriger vaut donc $-\sin^2\theta$ et varie donc comme le carré de l'écart minimal ou bruit $e^2k$ lorsque, comme ici, le module $/\overrightarrow{dk}/$ est une constante du récepteur. L'angle $\theta$ étant limité, on peut au besoin, pour la simplicité des calculs, considérer que $\sin\theta = \mathrm{tg}\,\theta = \theta$ (rd)

Le module du vecteur bruité $/\overrightarrow{dk}/$ est ici, comme indiqué, une valeur fixée, c'est-à-dire stabilisée par les circuits de réception en fonction du niveau de signal de la liaison d'entrée.

Le niveau de signal de symbole est ici amplifié par multiplication par $1/F = 1/\cos^2\theta$ ou, en variante, l'échelle est multipliée par $F$, pour que le signal utile $\overrightarrow{d^*k}$ remonte au niveau nominal prévu.

On peut en particulier déterminer le taux de bruit :

$$\sin\theta = /\overrightarrow{ek}/ / /\overrightarrow{dk}/ \qquad (\text{ou} = /\overrightarrow{ek}/ / /\overrightarrow{dk}/ = \mathrm{tg}\,\theta)$$

pour calculer ensuite l'inverse de $\cos^2\theta = F$.

L'erreur quadratique $/\overrightarrow{ek}/^2$ peut être estimée par un calcul de variance, par rapport aux niveaux nominaux, portant sur un nombre déterminé de symboles antérieurs, ce qui fournit $\sin^2\theta$ après avoir normé la variance par le module $/\overrightarrow{dk}/$ du vecteur bruité, et donc $\cos^2\theta$.

**Revendications**

1. Procédé d'égalisation de signaux de symboles de données reçus par un modem, dans lequel :

   - on transforme chaque symbole reçu actuel en un signal de niveau de tension spécifique à chaque symbole possible,
   - on compare le niveau de symbole actuel à une échelle des niveaux attendus de symboles pour déterminer un écart minimal (ek) de décalage du symbole actuel dans l'échelle,
   - en fonction de l'écart (ek), on règle des paramètres d'égalisation, par recalage relatif, entre les symboles ultérieurs et l'échelle, et
   - on effectue le recalage relatif du symbole reçu suivant avant d'effectuer sa comparaison à l'échelle,

   procédé **caractérisé par le fait qu'**on modifie les niveaux relatifs, du signal de niveau et de l'échelle, par un facteur de gain fonction dudit écart minimal (ek).

2. Procédé selon la revendication 1, dans lequel

   - on estime, d'après l'écart minimal (ek), une puissance de bruit ($e^2k$), associée au symbole adapté actuel bruité ($d^2k$), que l'on retranche à la puissance de ce dernier, que l'on a calculée, pour déterminer une puissance de symbole utile ($d^{*2}k$),
   - on calcule le rapport entre la puissance du symbole actuel bruité ($d^2k$) et la puissance du symbole utile ($d^{*2}k$), et
   - pour effectuer le recalage du symbole suivant, on modifie les niveaux relatifs, du signal de niveau et de l'échelle, par un facteur de gain représentant ledit rapport des puissances.

3. Procédé selon la revendication 2, dans lequel on estime le bruit par calcul de la variance portant sur un nombre déterminé de symboles antérieurs.

4. Procédé selon l'une des revendications 1 et 2, dans lequel on représente vectoriellement le signal de symbole bruité $(\overrightarrow{dk})$ et le signal de symbole non-bruité $(\overrightarrow{d^*k})$ et on calcule l'inverse du carré du cosinus de l'angle formé entre les vecteurs du signal bruité $(\overrightarrow{dk})$ et du signal non bruité $(\overrightarrow{d^*k})$, pour obtenir le facteur de gain à appliquer au symbole suivant.

5. Procédé selon l'une des revendications 2 et 3, dans lequel on calcule le rapport d'amplitudes bruit (ek) / signal bruité (dk), que l'on considère comme étant une valeur de sinus d'un angle, pour calculer l'inverse du carré du cosinus correspondant afin d'obtenir le facteur de gain.

6. Modem pour la mise en oeuvre du procédé de la revendication 1, comportant des moyens (1) d'égalisation de signaux de divers symboles reçus, commandant des moyens de transformation des symboles reçus en signaux correspondants de niveaux spécifiques et prévus pour les appliquer à des moyens de comparaison multiniveaux (3) agencés pour déterminer un écart minimal (ek) entre un symbole reçu actuel et des niveaux nominaux et d'une échelle des divers symboles attendus et commander en retour les moyens d'égalisation (1), **caractérisé par le fait que** les moyens de comparaison multiniveaux (3) sont agencés pour en outre commander des moyens (5) de calcul d'un taux de bruit des symboles reçus, prévus pour commander des moyens (2) de contrôle de gain relatif entre les niveaux des symboles reçus et les niveaux nominaux de l'échelle.

7. Modem selon la revendication 6, dans lequel les moyens de calcul (5) sont agencés pour calculer une puissance de bruit ($e^2k$) d'un symbole actuel, à partir d'un écart de niveau en sortie des moyens comparateurs multiniveaux (3), pour la retrancher à une puissance déterminée de symbole bruité reçu préalablement, afin d'obtenir une puissance de symbole non bruité, pour calculer le rapport des deux puissances de symbole, bruité/non bruité, et pour commander les moyens de contrôle de gain (2) en fonction dudit rapport.

8. Modem selon l'une des revendications 6 et 7, dans lequel les moyens de calcul (5) sont agencés pour déterminer, d'après l'écart minimal (ek), un angle de déviation ($\theta$) entre un vecteur représentant un symbole reçu bruité et un vecteur du même symbole sans bruit, et pour faire varier le gain des moyens de contrôle de gain (2) selon l'inverse du carré du cosinus dudit angle ($\theta$).

FIGURE 1

FIGURE 2

FIGURE 3

**Office européen des brevets**

# RAPPORT DE RECHERCHE EUROPEENNE

Numéro de la demande

EP 02 29 0351

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 5 214 675 A (BORTH DAVID E ET AL) 25 mai 1993 (1993-05-25) | 1,6 | H03G3/30 H03G3/20 |
| A | * colonne 4, ligne 8 - colonne 5, ligne 60 * | 3 | |
| | * colonne 8, ligne 15 - colonne 9, ligne 55 * | | |
| | * colonne 13, ligne 62 - colonne 14, ligne 20 * | | |
| | * colonne 14, ligne 36 - ligne 63 * | | |
| X | JIA Q -W ET AL: "A novel AGC scheme for DFE read channels" 2000 INTERNATIONAL MAGNETICS CONFERENCE (INTERMAG 2000);TORONTO, ONT, CANADA APR 9-12 2000, vol. 36, no. 5 I, 9 avril 2000 (2000-04-09), pages 2210-2212, XP002182225 IEEE Trans Magn;IEEE Transactions on Magnetics September 2000 * page 2210, colonne de gauche, alinéa 1 * * page 2210, colonne de droite, alinéa 2 * * figure 1 * | 1,6 | |
| A | WO 00 54431 A (NOKIA NETWORKS OY ;PIIRAINEN OLLI (FI)) 14 septembre 2000 (2000-09-14) * abrégé * * page 2, alinéa 4 * * page 3, alinéa 4 * * page 5, alinéa 3 - page 6, alinéa 3 * * page 7, alinéa 2 - alinéa 4 * * page 7, alinéa 6 - page 8, alinéa 2 * * page 9, alinéa 2 * | 1,3,4,6, 8 | |
| A | EP 0 524 806 A (NOKIA MOBILE PHONES LTD) 27 janvier 1993 (1993-01-27) * colonne 2, ligne 5 - ligne 25 * | 1,6 | |

DOMAINES TECHNIQUES RECHERCHES (Int.Cl.7)

H03G

Le présent rapport a été établi pour toutes les revendications

| Lieu de la recherche | Date d'achèvement de la recherche | Examinateur |
|---|---|---|
| LA HAYE | 15 mai 2002 | Litton, R |

**ANNEXE AU RAPPORT DE RECHERCHE EUROPEENNE**
**RELATIF A LA DEMANDE DE BREVET EUROPEEN NO.**

EP 02 29 0351

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

15-05-2002

| Document brevet cité au rapport de recherche | | Date de publication | Membre(s) de la famille de brevet(s) | | Date de publication |
|---|---|---|---|---|---|
| US 5214675 | A | 25-05-1993 | AU | 1919392 A | 11-02-1993 |
| | | | CA | 2087520 A1 | 03-01-1993 |
| | | | CN | 1068228 A ,B | 20-01-1993 |
| | | | DE | 4292231 C2 | 16-11-1995 |
| | | | DE | 4292231 T0 | 07-10-1993 |
| | | | FR | 2679085 A1 | 15-01-1993 |
| | | | GB | 2263048 A ,B | 07-07-1993 |
| | | | GB | 2292293 A ,B | 14-02-1996 |
| | | | IT | 1254400 B | 14-09-1995 |
| | | | JP | 3112029 B2 | 27-11-2000 |
| | | | JP | 6501366 T | 10-02-1994 |
| | | | KR | 9612425 B1 | 20-09-1996 |
| | | | MX | 9203905 A1 | 01-01-1993 |
| | | | SE | 502305 C2 | 02-10-1995 |
| | | | SE | 9203808 A | 03-01-1993 |
| | | | US | 5379324 A | 03-01-1995 |
| | | | US | 5446763 A | 29-08-1995 |
| | | | WO | 9301673 A1 | 21-01-1993 |
| WO 0054431 | A | 14-09-2000 | WO | 0054431 A1 | 14-09-2000 |
| | | | AU | 2729499 A | 28-09-2000 |
| | | | EP | 1159790 A1 | 05-12-2001 |
| EP 0524806 | A | 27-01-1993 | FI | 913529 A | 24-01-1993 |
| | | | DE | 69222900 D1 | 04-12-1997 |
| | | | DE | 69222900 T2 | 02-04-1998 |
| | | | EE | 3246 B1 | 15-12-1999 |
| | | | EP | 0524806 A1 | 27-01-1993 |
| | | | US | 5291150 A | 01-03-1994 |

EPO FORM P0460

Pour tout renseignement concernant cette annexe : voir Journal Officiel de l'Office européen des brevets, No.12/82